(19) Europäisches Patentamt
European Patent Office
Office européen des brevets

(11) **EP 1 895 518 A1**

(12) **EUROPEAN PATENT APPLICATION**

(43) Date of publication:
**05.03.2008 Bulletin 2008/10**

(51) Int Cl.:
**G11B 5/64** *(2006.01)* **G11B 5/851** *(2006.01)*
**C23C 14/34** *(2006.01)*

(21) Application number: **06255301.1**

(22) Date of filing: **16.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **01.09.2006 US 514175**

(71) Applicant: **Heraeus, Inc.**
**Chandler AZ 85226 (US)**

(72) Inventors:
• **Das, Anirban**
  **Chandler, AZ 85225 (US)**
• **Racine, Michael Gene**
  **Phoenix, AZ 85044 (US)**
• **Kennedy, Steven Roger**
  **Chandler, AZ 85226 (US)**

(74) Representative: **Hill, Justin John et al**
**McDermott Will & Emery UK LLP**
**7 Bishopsgate**
**London EC2N 3AR (GB)**

(54) **Magnetic recording media and sputter targets with compositions of high anisotropy alloys and oxide compounds**

(57) A magnetic data storage layer includes a high-$K_u$ alloy and an oxide compound of oxygen and either a single element or an alloy. Because of their high $K_u$, the magnetic domains of this magnetic data storage layer can be made significantly smaller, while maintaining an acceptable thermal stability ratio of about 50 to 70, to provide areal densities of greater than 200 Gb/in . Sputter targets for sputtering such a magnetic data storage layer are also provided. The sputter targets include the high-Ku alloy and either the desired oxide compounds, or the elements to be oxidized in a reactive sputtering process. The high-$K_u$ alloy has an anisotropy constant of at least $0.5 \times 10^7$ ergs/cm³.

EP 1 895 518 A1

**Description**

FIELD OF THE INVENTION

The present invention relates to magnetic recording media and, more particularly, to magnetic recording media having magnetic data storage layers with high areal densities, as well as sputter targets for producing such magnetic data storage layers.

BACKGROUND OF THE INVENTION

To increase the areal density of a magnetic recording medium, the size of individual magnetic domains in a storage layer of the medium must be scaled down. This may be accomplished by achieving lower grain sizes in the magnetic storage layer. To maintain an acceptable thermal stability ratio in each magnetic domain as the size thereof is reduced, it is desirable to use materials with high anisotropy constants.

Accordingly, there is a need to provide magnetic recording media with smaller magnetic domains and acceptable thermal stability ratios, as well as sputter targets for forming such magnetic recording media. The present invention satisfies these needs and provides other advantages as well.

SUMMARY OF THE INVENTION

In accordance with the present invention, a magnetic data storage layer includes a high-$K_u$ alloy and an oxide compound (of oxygen and either a single element or an alloy). Because of their high $K_u$, the magnetic domains of this magnetic data storage layer can be made significantly smaller, while maintaining an acceptable thermal stability ratio of about 50 to 70, to provide areal densities of greater than 200 Gb/in$^2$. Sputter targets for sputtering such a magnetic data storage layer are also provided. The sputter targets include the high-$K_u$ alloy and either the desired oxide compounds, or the elements to be oxidized in a reactive sputtering process.

According to one embodiment of the present invention, a magnetic recording medium has a magnetic data storage layer which includes a first alloy having an anisotropy constant of at least $0.5 \times 10^7$ ergs/cm$^3$ and an oxide compound of oxygen and one or more elements, at least one of the one or more elements having a negative reduction potential.

According to another embodiment of the present invention, a sputter target includes a first alloy having an anisotropy constant of at least $0.5 \times 10^7$ ergs/cm$^3$ and an oxide compound of oxygen and one or more elements, at least one of the one or more elements having a negative reduction potential.

According to another embodiment of the present invention, a sputter target includes a first alloy having an anisotropy constant of at least $0.5 \times 10^7$ ergs/cm$^3$ and a second material including one or more elements, at least one of the one or more elements having a negative reduction potential.

It is to be understood that both the foregoing summary of the invention and the following detailed description are exemplary and explanatory and are intended to provide further explanation of the invention as claimed.

BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention. In the drawings:

Figure 1A illustrates a magnetic recording medium according to one embodiment of the present invention;

Figure 1B illustrates a magnetic data storage layer according to one aspect of the present invention;

Figure 2 illustrates a sputter target according to another embodiment of the present invention; and

Figure 3 illustrates a sputter target being sputtered to generate a film according to one aspect of the present invention.

DETAILED DESCRIPTION OF THE INVENTION

In the following detailed description, numerous specific details are set forth to provide a full understanding of the present invention. It will be apparent, however, to one ordinarily skilled in the art that the present invention may be practiced without some of these specific details. In other instances, well-known structures and techniques have not been shown in detail to avoid unnecessarily obscuring the present invention.

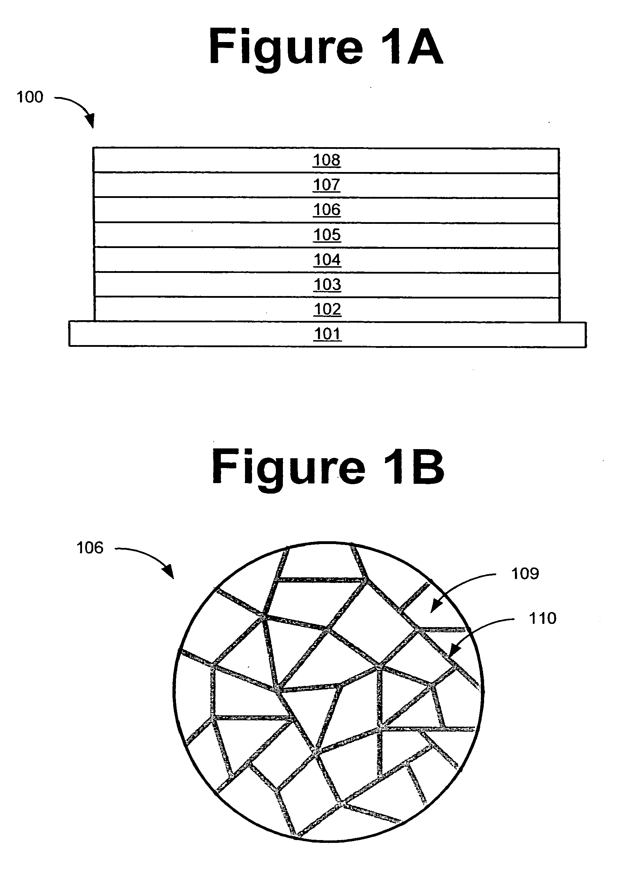

Figure 1A illustrates a magnetic recording media stack 100 according to one embodiment of the present invention. Magnetic recording media stack 100 includes a substrate 101 (*e.g.*, glass or aluminum), a seed layer 104, an underlayer 105 and a magnetic data storage layer 106. Magnetic recording media stack 100 may also include one or more soft underlayers with or without other non-magnetic or magnetic layers, such as layers 102 and 103, disposed on substrate 101. Magnetic recording media stack 100 may further include a lube layer and a carbon overcoat with or without other magnetic or non-magnetic layers, such as layers 107 and 108.

Figure 1B illustrates magnetic data storage layer 106 in further detail. Magnetic data storage layer 106 is made up of two different materials, one of which is an oxide compound for refining the grain size of magnetic data storage layer 106, the other of which has a high anisotropy constant $K_u$ to ensure an acceptable thermal stability ratio.

The presence of the oxide compound acts to refine the grain size of magnetic data storage layer 106. This occurs as a result of the oxide compound being disposed in oxide-rich grain boundary phases 110, which act to separate the magnetic grains 109 of the high-$K_u$ material, thereby contributing to the effective exchange decoupling of magnetic domains and an improved signal-to-noise ratio ("SNR").

According to one aspect, the oxide compound is a compound of oxygen and a single element with a negative reduction potential. According to another aspect, the oxide compound is a compound of oxygen and multiple elements, at least one of which has a negative reduction potential. Table 1, below, illustrates a number of metals and metalloids with negative reduction potentials that are suitable for use as an oxide in a magnetic data storage layer of the present invention.

**Table 1**

| Element | Reduction Potential (eV) | | Element | Reduction Potential (eV) |
|---------|--------------------------|---|---------|--------------------------|
| Li | -3.04 | | Cd | -0.4025 |
| Be | -1.97 | | In | -0.33 |
| B | -0.89 | | Cs | -2.923 |
| Na | -2.713 | | Ba | -2.92 |
| Mg | -2.356 | | La | -2.38 |
| A1 | -1.676 | | Ce | -2.34 |
| Si | -0.909 | | Pr | -2.35 |
| K | -2.925 | | Nd | -2.32 |
| Ca | -2.84 | | Sm | -2.3 |
| Sc | -2.03 | | Eu | -1.99 |
| Ti | -0.86 | | Tb | -2.31 |
| V | -0.236 | | Gd | -2.28 |
| Cr | -0.74 | | Ho | -2.33 |
| Fe | -0.04 | | Er | -2.32 |
| Fe | -0.44 | | Tm | -2.32 |
| Co | -0.28 | | Yb | -2.22 |
| Ni | -0.257 | | Lu | -2.3 |
| Zn | -0.792 | | Hf | -1.7 |
| Ga | -0.53 | | Ta | -0.81 |
| Rb | -2.924 | | W | -0.09 |
| Sr | -2.89 | | Pb | -0.125 |
| Y | -2.37 | | Th | -1.83 |
| Zr | -1.55 | | U | -1.38 |
| Nb | -0.65 | | | |

The thermal stability ratio for the magnetic domains of magnetic data storage layer 106 is given by Equation 1:

$$K_u V / k_B T \qquad\qquad . \qquad\qquad (1)$$

where $K_u$ is the anisotropy constant of the material of the magnetic domain, $V$ is the size of the magnetic domain, $k_B$ is the Boltzmann constant, and $T$ is the temperature of the magnetic domain in degrees Kelvin. As can be seen with reference to Equation 1, as the size $V$ of a magnetic domain decreases, the anisotropy constant $K_u$ must be increased to maintain the same thermal stability ratio. Accordingly, the high-$K_u$ material permits the magnetic domains of magnetic data storage layer 106 to maintain an acceptable thermal stability ratio of about 50 to 70 as the size of the magnetic domains is reduced.

According to one aspect, the high-$K_u$ material has an anisotropy constant of at least $0.5 \times 10^7$ ergs/cm$^3$. For example, the high-$K_u$ material may be chosen from materials such as L1$_0$-type ordered intermetallics, ordered HCP intermetallics, and rare earth transition metal alloys. Table 2, below, illustrates a number of materials with high anisotropy constants that are suitable for use as a first material in a magnetic data storage layer of the present invention.

**Table 2**

| Alloy System | Material | $K_u$ ($10^7$ ergs/cm$^3$) |
|---|---|---|
| L1$_0$-type ordered intermetallics | FePd | 1.8 |
| | FePt | 6.6-10 |
| | CoPt | 4.9 |
| | MnAl | 1.7 |
| Ordered HCP intermetallics | Co$_3$Pt | 2.0 |
| Rare earth transition metal alloys | Fe$_{14}$Nd$_2$B | 4.6 |
| | SmCo$_5$ | 11-20 |

While magnetic recording media stack 100 has been described with reference to a particular arrangement of layers, it will be apparent to one of skill in the art that the scope of the present invention is not limited to such an arrangement. Rather, the present invention has application to magnetic recording media which include more or less layers than magnetic recording media stack 100, and which are disposed in any arrangement known to those of skill in the art.

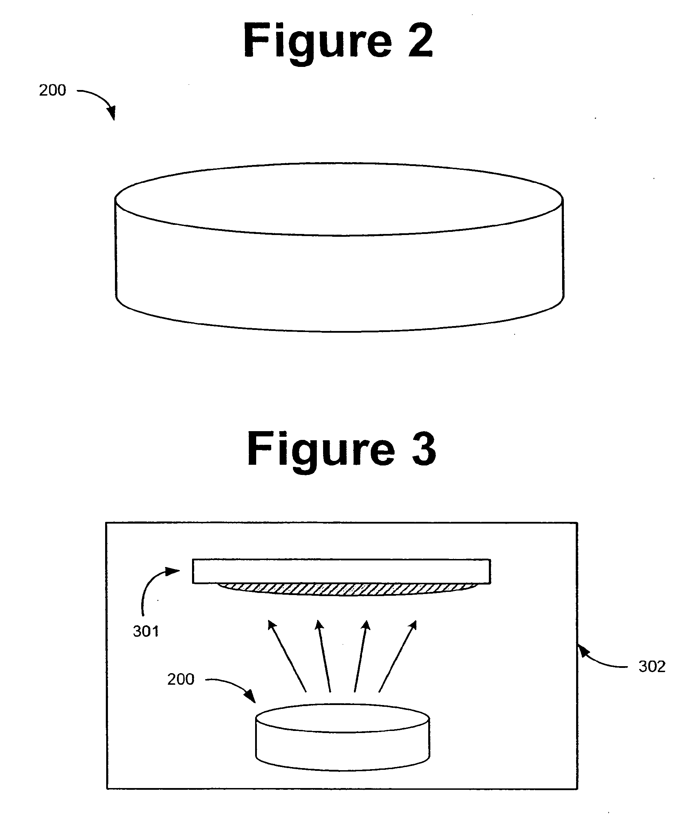

Turning to Figure 2, a sputter target 200 is illustrated according to one embodiment of the present invention. Sputter target 200 may be used to sputter a film such as magnetic data storage layer 106. According to one embodiment of the present invention, sputter target 200 is made up of two different materials, one of which is an oxide compound (*e.g.,* an oxide of one or more of the elements listed in Table 1) for refining the grain size of a magnetic data storage layer sputtered therefrom, the other of which has a high anisotropy constant $K_u$ (*e.g.,* one of the alloys listed in Table 2) to ensure an acceptable thermal stability ratio in a magnetic data storage layer sputtered therefrom. According to one aspect, these two materials are combined in sputter target 200 as a single alloy. According to alternate aspects, these two materials may be provided as separate regions of sputter target 200, or combined in any one of a number of other ways readily apparent to those of skill in the art.

According to another embodiment of the present invention, in which sputter target 200 is used to reactively sputter, in the presence of oxygen, a film such as magnetic data storage layer 106, sputter target 200 does not include an oxide compound. Rather, in addition to a high-$K_u$ material (*e.g.*, one of the alloys listed in Table 2), sputter target 200 includes a second material made up of one or more elements, at least one of which has a negative reduction potential (*e.g.*, one or more of the elements listed in Table 1). This second material will combine with oxygen during the reactive sputtering process to provide the oxide compound for refining the grain size of a magnetic data storage layer reactively sputtered therefrom. According to one aspect, these two materials are combined in sputter target 200 as a single alloy. According to alternate aspects, these two materials may be provided as separate regions of sputter target 200, or combined in any one of a number of other ways readily apparent to those of skill in the art.

Figure 3 illustrates sputter target 200 being sputtered to generate a film 300 on a substrate 301 according to one aspect of the present invention. In the sputtering process, sputter target 200 is positioned in a sputtering chamber 302, which is partially filled with an inert gas. Sputter target 200 is exposed to an electric field to excite the inert gas to generate plasma. Ions within plasma collide with a surface of sputter target 200 causing molecules to be emitted from the surface of sputter target 200. A difference in voltage between sputter target 200 and substrate 301 causes the emitted molecules to form the desired film 300 on the surface of substrate 301.

According to another aspect of the present invention, in which sputter target 200 is reactively sputtered in the presence of oxygen, sputtering chamber 302 is partially filled with both an inert gas and oxygen. Sputter target 200 is exposed to an electric field to excite both gas species to generate plasma. Some of the negative reduction potential elements which have been ejected off of sputter target 200 chemically react with oxygen in the plasma to form oxide compounds, which are deposited in film 300 on the surface of substrate 301.

While the present invention has been particularly described with reference to the various figures and embodiments, it should be understood that these are for illustration purposes only and should not be taken as limiting the scope of the invention. There may be many other ways to implement the invention. Many changes and modifications may be made to the invention, by one having ordinary skill in the art, without departing from the spirit and scope of the invention.

**Claims**

1.  A magnetic recording medium having a magnetic data storage layer, the magnetic data storage layer comprising:

    a first alloy having an anisotropy constant of at least $0.5 \times 10^7$ ergs/cm$^3$; and
    an oxide compound of oxygen and one or more elements, at least one of the one or more elements having a negative reduction potential.

2.  The magnetic recording medium of claim 1, wherein the first alloy is selected from the group consisting of L1$_0$-type ordered intermetallics, ordered HCP intermetallics, and rare earth transition metal alloys.

3.  The magnetic recording medium of claim 1, wherein the oxide compound is disposed in oxide-rich grain boundaries separating magnetic grains of the first alloy.

4.  The magnetic recording medium of claim 1, wherein the first alloy is selected from the group consisting of FePt, FePd, CoPt, MnA1, Co$_3$Pt, SmCo$_5$ and Fe$_{14}$Nd$_2$B.

5.  The magnetic recording medium of claim 1, wherein at least one of the one or more elements in the oxide compound is a metal or a metalloid.

6.  The magnetic recording medium of claim 1, wherein at least one of the one or more elements in the oxide compound is selected from the group consisting of lithium (Li), beryllium (Be), boron (B), sodium (Na), magnesium (Mg), aluminum (Al), silicon (Si), potassium (K), calcium (Ca), scandium (Sc), titanium (Ti), vanadium (V), chromium (Cr), manganese (Mn), iron (Fe), cobalt (Co), nickel (Ni), zinc (Zn), gallium (Ga), rubidium (Rb), strontium (Sr), yttrium (Y), zirconium (Zr), niobium (Nb), cadmium (Cd), indium (In), cesium (Cs), barium (Ba), lanthanum (La), cerium (Ce), praseodymium (Pr), neodymium (Nd), samarium (Sm), europium (Eu), terbium (Tb), gadolinium (Gd), holmium (Ho), erbium (Er), thulium (Tm), ytterbium (Yb), lutetium (Lu), hafnium (Hf), tantalum (Ta), tungsten (W), lead (Pb), thorium (Th) and uranium (U).

7.  A sputter target comprising a first alloy having an anisotropy constant of at least $0.5 \times 10^7$ ergs/cm$^3$, and an oxide compound of oxygen and one or more elements, at least one of the one or more elements having a negative reduction potential.

8.  The sputter target of claim 7, wherein the first alloy and the oxide compound are alloyed.

9.  The sputter target of claim 7, wherein the first alloy is selected from the group consisting of Ll$_0$-type ordered intermetallics, ordered HCP intermetallics, and rare earth transition metal alloys.

10. The sputter target of claim 7, wherein the first alloy is selected from the group consisting of FePt, FePd, CoPt, MnAl, Co$_3$Pt, SmCo$_5$ and Fe$_{14}$Nd$_2$B.

11. The sputter target of claim 7, wherein at least one of the one or more elements in the oxide compound is a metal or a metalloid.

12. The sputter target of claim 7, wherein at least one of the one or more elements in the oxide compound is selected from the group consisting of lithium (Li), beryllium (Be), boron (B), sodium (Na), magnesium (Mg), aluminum (Al), silicon (Si), potassium (K), calcium (Ca), scandium (Sc), titanium (Ti), vanadium (V), chromium (Cr), manganese (Mn), iron (Fe), cobalt (Co), nickel (Ni), zinc (Zn), gallium (Ga), rubidium (Rb), strontium (Sr), yttrium (Y), zirconium (Zr), niobium (Nb), cadmium (Cd), indium (In), cesium (Cs), barium (Ba), lanthanum (La), cerium (Ce), praseodymium (Pr), neodymium (Nd), samarium (Sm), europium (Eu), terbium (Tb), gadolinium (Gd), holmium (Ho), erbium (Er), thulium (Tm), ytterbium (Yb), lutetium (Lu), hafnium (Hf), tantalum (Ta), tungsten (W), lead (Pb), thorium (Th) and uranium (U).

13. A film sputtered from the sputter target of claim 7, wherein the oxide compound is disposed in the film within oxide-rich grain boundaries separating magnetic grains of the first alloy.

14. A sputter target comprising a first alloy having an anisotropy constant of at least $0.5 \times 10^7$ ergs/cm$^3$, and a second material including one or more elements, at least one of the one or more elements having a negative reduction potential.

15. The sputter target of claim 14, wherein the first alloy and the second material are alloyed.

16. The sputter target of claim 14, wherein the first alloy is selected from the group consisting of $L1_0$-type ordered intermetallics, ordered HCP intermetallics, and rare earth transition metal alloys.

17. The sputter target of claim 14, wherein the first alloy is selected from the group consisting of FePt, FePd, CoPt, MnAl, $Co_3Pt$, $SmCo_5$ and $Fe_{14}Nd_2B$.

18. The sputter target of claim 14, wherein at least one of the one or more elements in the oxide compound is a metal or a metalloid.

19. The sputter target of claim 14, wherein at least one of the one or more elements in the oxide compound is selected from the group consisting of lithium (Li), beryllium (Be), boron (B), sodium (Na), magnesium (Mg), aluminum (Al), silicon (Si), potassium (K), calcium (Ca), scandium (Sc), titanium (Ti), vanadium (V), chromium (Cr), manganese (Mn), iron (Fe), cobalt (Co), nickel (Ni), zinc (Zn), gallium (Ga), rubidium (Rb), strontium (Sr), yttrium (Y), zirconium (Zr), niobium (Nb), cadmium (Cd), indium (In), cesium (Cs), barium (Ba), lanthanum (La), cerium (Ce), praseodymium (Pr), neodymium (Nd), samarium (Sm), europium (Eu), terbium (Tb), gadolinium (Gd), holmium (Ho), erbium (Er), thulium (Tm), ytterbium (Yb), lutetium (Lu), hafnium (Hf), tantalum (Ta), tungsten (W), lead (Pb), thorium (Th) and uranium (U).

20. A film reactively sputtered from the sputter target of claim 14 in the presence of oxygen, wherein oxides of the second material are disposed in the film within oxide-rich grain boundaries separating magnetic grains of the first alloy.

# Figure 1A

100

| 108 |
|:---:|
| 107 |
| 106 |
| 105 |
| 104 |
| 103 |
| 102 |
| 101 |

# Figure 1B

106

109

110

# Figure 2

200

# Figure 3

301

200

302

**EP 1 895 518 A1**

**European Patent Office**

**PARTIAL EUROPEAN SEARCH REPORT**

which under Rule 45 of the European Patent Convention shall be considered, for the purposes of subsequent proceedings, as the European search report

Application Number

EP 06 25 5301

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/121319 A1 (WU ET AL.) 8 June 2006 (2006-06-08) * claims 1,11,13,18,19,22 * ----- | 1-20 | INV. G11B5/64 G11B5/851 C23C14/34 |
| X | US 2005/214590 A1 (MAEDA ET AL.) 29 September 2005 (2005-09-29) * paragraphs [0079], [0080]; table 2 * ----- | 1-20 | |
| X | US 2004/202843 A1 (MORIWAKI ET AL.) 14 October 2004 (2004-10-14) * paragraph [0040]; claims 1-4 * ----- | 1-20 | |
| X | US 2005/255336 A1 (MUKAI) 17 November 2005 (2005-11-17) * paragraphs [0086] - [0088], [0109]; figure 2 * ----- | 1-20 | |
| X | US 2004/247941 A1 (CHEN ET AL.) 9 December 2004 (2004-12-09) * paragraphs [0015], [0016]; claims 3,4 * ----- -/-- | 1-20 | TECHNICAL FIELDS SEARCHED (IPC) G11B C23C |

## INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| The Hague | 5 April 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

9

European Patent
Office

**PARTIAL EUROPEAN SEARCH REPORT**

Application Number

EP 06 25 5301

| DOCUMENTS CONSIDERED TO BE RELEVANT | | | CLASSIFICATION OF THE APPLICATION (IPC) |
|---|---|---|---|
| Category | Citation of document with indication, where appropriate, of relevant passages | Relevant to claim | |
| X | EP 1 365 390 A (FUJI) 26 November 2003 (2003-11-26) * page 4, line 19 - line 31 * * page 4, line 41 - line 47; claims 1-4 * ----- | 1-20 | |
| X | US 2005/106422 A1 (LU ET AL.) 19 May 2005 (2005-05-19) * paragraphs [0007], [0026] * ----- | 1-20 | |

TECHNICAL FIELDS SEARCHED (IPC)

EPO FORM 1503 03.82 (P04C10)

**European Patent Office**

**INCOMPLETE SEARCH SHEET C**

Application Number

EP 06 25 5301

---

Claim(s) searched completely:
2-6,8-12,15-19

Claim(s) searched incompletely:
1,7,13,14,20

Reason for the limitation of the search:

Present claims 1, 7, 13, 14, 20 relate to products which have a given desired property or effect, namely anisotropy constant of at least 5000000 ergs/cm3. However, the description does not provide support and disclosure in the sense of Article 84 and 83 EPC for any such products having the said property or effect and there is no common general knowledge of this kind available to the person skilled in the art. This non-compliance with the substantive provisions is to such an extent, that a meaningful search of the whole claimed subject-matter of the claim could not be carried out (Rule 45 EPC and Guidelines B-VIII, 3).

The search of claims 1, 7, 13, 14, 20 was consequently restricted to the specifically disclosed products having the desired property or effect, see claims 2-6, 8-12, 15-19, and to the broad concept of a product having the desired property or effect.

## ANNEX TO THE EUROPEAN SEARCH REPORT
## ON EUROPEAN PATENT APPLICATION NO.

EP 06 25 5301

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2007

| Patent document cited in search report | | Publication date | Patent family member(s) | | Publication date |
|---|---|---|---|---|---|
| US 2006121319 | A1 | 08-06-2006 | NONE | | |
| US 2005214590 | A1 | 29-09-2005 | CN | 1674101 A | 28-09-2005 |
| | | | JP | 2005276366 A | 06-10-2005 |
| | | | SG | 115799 A1 | 28-10-2005 |
| US 2004202843 | A1 | 14-10-2004 | JP | 2003208710 A | 25-07-2003 |
| US 2005255336 | A1 | 17-11-2005 | CN | 1697030 A | 16-11-2005 |
| | | | CN | 1707624 A | 14-12-2005 |
| US 2004247941 | A1 | 09-12-2004 | NONE | | |
| EP 1365390 | A | 26-11-2003 | JP | 2003346318 A | 05-12-2003 |
| | | | US | 2003219629 A1 | 27-11-2003 |
| US 2005106422 | A1 | 19-05-2005 | NONE | | |

EPO FORM P0459

For more details about this annex : see Official Journal of the European Patent Office, No. 12/82